(19) Europäisches Patentamt
European Patent Office
Office européen des brevets

(11) **EP 3 948 951 B1**

(12) **EUROPÄISCHE PATENTSCHRIFT**

(45) Veröffentlichungstag und Bekanntmachung des Hinweises auf die Patenterteilung:
**20.11.2024 Patentblatt 2024/47**

(21) Anmeldenummer: **20715840.3**

(22) Anmeldetag: **30.03.2020**

(51) Internationale Patentklassifikation (IPC):
*H01L 27/146* (2006.01)     *H01L 31/107* (2006.01)

(52) Gemeinsame Patentklassifikation (CPC):
**H01L 27/14643; H01L 31/107**

(86) Internationale Anmeldenummer:
**PCT/EP2020/058904**

(87) Internationale Veröffentlichungsnummer:
**WO 2020/201189 (08.10.2020 Gazette 2020/41)**

(54) **AVALANCHE-PHOTODIODEN-ARRAY**

AVALANCHE PHOTODIODE ARRAY

RÉSEAU DE PHOTODIODES À AVALANCHE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.04.2019 DE 102019204701**

(43) Veröffentlichungstag der Anmeldung:
**09.02.2022 Patentblatt 2022/06**

(73) Patentinhaber: **Max-Planck-Gesellschaft zur Förderung der Wissenschaften e.V.
80539 München (DE)**

(72) Erfinder:
• **RICHTER, Rainer**
  **81243 München (DE)**
• **SCHOPPER, Florian**
  **80802 München (DE)**
• **NINKOVIC, Jelena**
  **80999 München (DE)**
• **BÄHR, Alexander**
  **82194 Gröbenzell (DE)**

(74) Vertreter: **Prüfer & Partner mbB
Patentanwälte · Rechtsanwälte
Sohnckestraße 12
81479 München (DE)**

(56) Entgegenhaltungen:
**US-A1- 2012 267 746     US-A1- 2018 097 132**

**Beschreibung**

Die vorliegende Anmeldung betrifft eine matrixförmige Anordnung von Silizium Avalanche-Photodioden (APDs) -- im folgenden APD-Array genannt zur Detektion von Strahlung, insbesondere elektromagnetischer Strahlung.

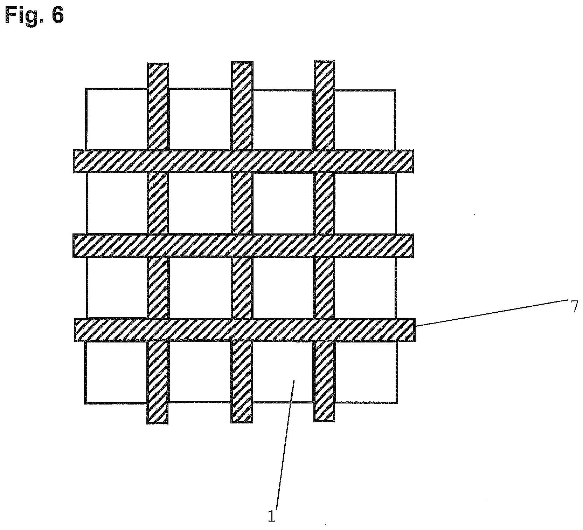

Avalanche-Photodioden nutzen die Stoßionisation von elektrischen Ladungsträgern zur Verstärkung des Signals. Sie werden als Sensoren für die Detektion von Photonen eingesetzt, die ihre Energie an den Halbleiterkristall abgeben und dabei Elektron-Loch-Paare erzeugen. Für die Detektion von Licht im sichtbaren Bereich (UV bis nahes Infrarot) sind sogenannte Reach-Through-APDs (RT-APDs) aus Silizium besonders gut geeignet, weil bei diesen Dioden das Licht an der Chip-Rückseite auf ein unstrukturiertes und an die Wellenlänge des zu detektierenden Lichtes angepasstes Lichteintrittsfenster fällt. Figur 6 zeigt beispielhaft den prinzipiellen Aufbau einer RT-APD und den elektrischen Feldverlauf.

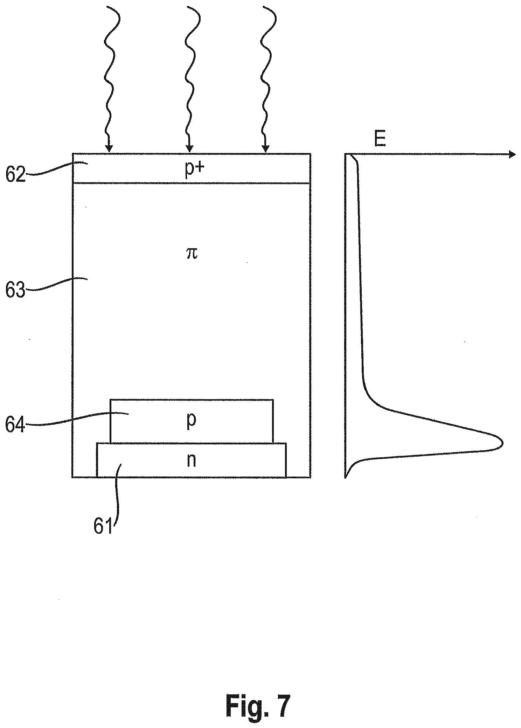

In der linken Hälfte der Figur 7 ist ein Schnitt durch eine einzelne APD senkrecht zu den Chipoberflächen schematisch dargestellt. Man erkennt einen stark n-dotierten Anodenbereich 61 an der Unterseite, welche in der Regel als Chipvorderseite angesehen wird, und einen stark p-dotierten Kathodenbereich 62 an der gegenüberliegenden Chipoberfläche, welche in der Regel als Chiprückseite angesehen wird. Den größten Teil des Chipsubstrats nimmt eine schwach p-dotierte bzw. nur intrinsisch leitende Driftregion 63 ein, die auf Grund ihrer sehr schwachen Dotierung durch die im Betrieb zwischen Anode und Kathode anliegende Sperrspannung vollständig verarmt ist. Je nach Wellenlänge konvertieren auf die Chiprückseite (Strahlungseintrittsseite) auftreffende Photonen im Bereich des Kathodenbereichs 62 oder in der Driftregion 63. Zur Erzeugung eines Sensorsignals müssen die generierten (Signal-)Elektronen im elektrischen Feld in der Driftregion 63 in Richtung des Anodenbereichs 61 auf der Chipvorderseite driften. Die intrinsische Verstärkung des Signals wird dabei durch eine zwischen Driftregion 63 und Anodenbereich 61 angeordnete Multiplikationsschicht 64 bewirkt. Diese ist deutlich stärker p-dotiert als die Driftregion 63 und im Sensorbetrieb bei anliegender Sperrspannung ebenfalls vollständig verarmt. Die rechte Hälfte von Fig. 7 zeigt die Feldstärke in Abhängigkeit von der Position relativ zur Chipvorder- und -rückseite. Infolge der stärkeren p-Dotierung erhöht sich die elektrische Feldstärke nahe dem pn-Übergang im Vergleich zur Feldstärke in der Driftregion so stark, dass es durch Stoßionisation zu einer Vervielfachung der Signalelektronen kommt, wodurch die intrinsische Verstärkung bewirkt wird.

Beim Betrieb einer APD wird grundsätzlich zwischen zwei verschiedenen Modi unterschieden, dem Proportionalmodus und dem Geigermodus. Im Proportionalmodus liegt die angelegte Sperrspannung unterhalb der Durchbruchsspannung, im Geigermodus darüber.

Die vorliegende Anmeldung ist auf im Proportionalmodus zu betreibende APDs gerichtet, bei denen das Ausgangssignal im Wesentlichen proportional zur Strahlungsleistung ist.

US 2012/0267746 A1 beschreibt ein im Geigermodus zu betreibendes APD-Array für Computertomographiesysteme. Jede Avalanche-Photodiode weist dabei neben einem Anodenkontakt und einem Kathodenkontakt eine von Anodenkontakt und Kathodenkontakt elektrisch isolierte Ausleseelektrode auf. Diese ist kapazitiv vom Halbleiter getrennt, wobei die Ausgangselektroden aller Avalanche-Photodioden elektrisch zusammengeschaltet sind.

Eine spezielle Variante einer RT-APD ist eine sogenannte SLIK-APD. SLIK steht hierbei für super low ionization k-factor, wobei der k-Faktor das Verhältnis der Löcherzur Elektronenionisationsrate bei einer bestimmten elektrischen Feldstärke bezeichnet. In der Regel wird ein geringer Wert für den k-Faktor bevorzugt, da Multiplikationen, die durch Löcher verursacht werden, das Zusatzrauschen einer APD deutlich verschlechtern. Eine APD, die im Proportionalmodus betrieben wird, hat daher idealerweise einen k-Faktor gleich 0, d. h. die Verstärkung basiert ausschließlich auf der Multiplikation von Elektronen, während die Löcher nicht beitragen. Während bei Silizium-RT-APDs k-Faktoren bis hinunter zu ungefähr 0,02 erzielt werden, können mit SLIK-APDs k-Faktoren erzielt werden, die um etwa eine Größenordnung niedriger liegen. SLIK-APDs sind daher für Anwendungen, die ein geringes Rauschen erfordern, besonders gut geeignet. Sie nutzen den Umstand, dass der k-Faktor bei geringeren elektrischen Feldstärken auch kleiner wird. Um den Verstärkungsverlust zu kompensieren, weisen sie daher eine senkrecht zu Chipvorder- und rückseite sehr ausgedehnte Multiplikationsschicht auf, die sich typischerweise über einige 10 $\mu$m erstrecken kann.

Da die Stoßionisation ein stochastischer Prozess ist, führt dieser Prozess zu einem zusätzlichen Rauschbeitrag bei der Signalverstärkung, der im Englischen als "excess noise" bezeichnet wird. Daher werden APDs vor allem in sehr schnellen Detektorsystemen (Signalbereitstellungszeit im Nanosekundenbereich und darunter) zusammen mit breitbandigen Verstärkern eingesetzt, gegenüber deren hohem weißen Rauschen das Zusatzrauschen der APDs nicht ins Gewicht fällt. Von Vorteil ist auch ein Einsatz von APDs in Systemen mit Sensorelementen, die eine große Eingangskapazität haben oder in denen die Performance der nachfolgenden verstärkenden Elemente aus Platzgründen oder wegen des Leistungsbedarfs eingeschränkt werden muss. Ein typisches Beispiel sind Diodenarrays, bei denen ein Mikroelektronik-Chip mit integrierter Ausleseelektronik per Flip-Chip-Technik über sogenannte Bump Bonds mit den Dioden verbunden wird.

Für bildgebende Detektoren braucht man idealerweise möglichst große Bildzellen-Matrizen (Arrays) mit kleinen Sensorpixeln, um einen möglichst großen Bereich mit guter Ortsauflösung vermessen zu können. Hierfür geeignete Silizium-pin-Dioden-Arrays können in Größen von einigen 10 Quadratzentimetern mit Pixelgrößen (p) im Bereich von 50 μm hergestellt werden. Derartige Detektorsysteme werden in der Hochenergiephysik und in verschiedensten Synchrotron-Experimenten erfolgreich eingesetzt. Die Ortsauflösung ist dabei sehr gut. Sie liegt bei $p/\sqrt{12}$ oder besser. Da allerdings pin-Dioden im Gegensatz zu APDs nicht über eine intrinsische Signalverstärkung verfügen, ist die Detektion schwacher und/oder schneller Signale entweder gar nicht oder nur mit sehr aufwändigen Ausleseverstärkern möglich. Besonders problematisch ist, dass die benötigten hochwertigen Verstärker auf Grund ihres Platz- und Leistungsbedarfs nicht in zehntausendfacher Ausführung auf einem Auslesechip integriert werden können. Beispielsweise generieren weiche Röntgenphotonen (soft x-rays) nur einige Hundert Signalelektronen. Da das Rauschen (z.B. ausgedrückt als äquivalente Rauschladung ENC) der verfügbaren Ausleseelektronik-Chips in den für viele Anwendungen interessanten kurzen Zeitbereichen ebenfalls bei einigen 100 Elektronen liegt, sind daher pin-Diodenarrays für die Detektion sehr schwacher Signale in der Regel nicht einsetzbar.

APDs würden das Problem lösen. Sie können derzeit jedoch nicht in großen Arrays mit kleinen Pixeln (Bildzellen) angeordnet werden. Beispielsweise weist ein zur Zeit kommerziell erhältliches APD-Array 4x8 Pixel und eine photosensitive Fläche von 1,6×1,6mm² auf (Hamamatsu Produktinformation https://www.hamamatsu.com/eu/en/product/tvpe/S8550-02/index.htm!). Ein wesentlicher Grund hierfür liegt in den Trennbereichen zwischen den stark n-dotierten Anoden benachbarter APD-Pixel (die eine gemeinsame Kathode aufweisen). Der Hintergrund ist der, dass zur Vermeidung von elektrischen Durchbrüchen die Anoden der APD-Pixel an den Rändern mit einer relativ großen Schutzstruktur umgeben werden müssen.

Die Neigung zu Durchbrüchen an den Rändern der APD-Pixel ist eine Folge der Krümmung des Dotierungsprofils an den Rändern der stark n-dotierten Anoden der Pixel. Durch die daraus resultierende erhöhte Dichte der elektrischen Feldlinien an den Rändern würde ohne hinreichende Gegenmaßnahmen die Lawinenverstärkung an den Rändern eines Pixels bei kleineren Spannungen einsetzen als im Pixelinneren, wodurch das gesamte Verstärkungsverhalten der APD durch ihren Randbereich dominiert werden würde. Bei den bekannten Schutzstrukturen wird dieser Effekt durch eine starke Reduzierung des elektrischen Feldes im Randbereich vermieden. Die Ladungsträgermultiplikation erfolgt nur im Inneren des Pixels und wird im Randbereich abgeschaltet.

Wenn bei einem APD-Pixelarray jedes einzelne Pixel einen Schutz- und Isolationsbereich aufweist, entstehen daher zwischen den sensitiven Bereichen der Pixel insensitive Totbereiche, wodurch die effektive Signalsammelfläche der einzelnen Pixel verringert ist. Damit die Totbereiche nicht das Ladungssammlungsverhalten des ganzen Arrays dominieren, müssen die Flächen der Anoden im Vergleich zu den weniger sensitiven oder insensitiven Flächen der Bereiche zwischen den Anoden groß sein, wodurch die Pixel groß sind, was zu Lasten der Ortsauflösung geht.

Die Einschränkung der effektiven Ladungssammlungsfläche der Sensorpixel eines APD-Sensorarrays wird üblicherweise mittels des Füllfaktors charakterisiert. Der Füllfaktor beschreibt dabei den Anteil der sensitiven Pixelfläche an der Gesamtpixelfläche. Ein ideales Sensorarray hätte also den Füllfaktor Eins.

Auch für SLIK-APDs gibt es derzeit keine befriedigende Lösung für ein pixeliertes Sensor-Array.

Im Rahmen der universitären Forschung wird an Arrays von Avalanchedioden-Arrays mit verbessertem Füllfaktor gearbeitet. Diese als LGAD (low gain avalanche detector) bezeichneten Arrays werden haben entweder streifenförmige oder pixelierte Diodenanordnungen. Hauptanwendungsgebiet ist die Detektion von ionisierenden Teilchen, z.B. in Hochenergiephysikexperimenten. Zwei Ansätze werden dabei derzeit verfolgt:

Das klassische LGAD verwendet RT-APDs (siehe N. Moffat et al., "Low Gain Avalanche Detectors (LGAD) for particle physics and synchrotron applications", Journal of Instrumentation, vol. 13, March 2018). Durch eine Minimierung der Schutzstrukturen soll der Füllfaktor verbessert werden. Beim invertierten LGAD (G. Pellegrini et al., "Recent Technological Developments on LGAD and iLGAD Detectors for Tracking and Timing Applications", arXiv.org > physics > arXiv: 1511.07175) werden nicht die Anoden segmentiert, sondern die p-dotierten Kathoden. Die Anoden und die Multiplikationsschicht können deshalb für das gesamte Array einheitlich ausgeführt werden und die Schutzstrukturen können entfallen, so dass der Füllfaktor gleich 1 ist. Der Nachteil dieses Konzepts ist allerdings, dass es nur für die Detektion von Teilchen geeignet ist, nicht jedoch als Photodetektor. Da die Kathodenseite strukturiert und metallisiert werden muss -hier befindet sich der Auslesechip des Pixeldetektors - ist sie als Lichteintrittsfenster nicht mehr geeignet. Bei Verwendung der Anodenseite als Lichteintrittsfenster werden Photonen, die in der Anode konvertieren überhaupt nicht verstärkt und bei Konversion in der Multiplikationsschicht variiert die Verstärkung je nach Konversionstiefe. Invertierte LGADs sind daher nur für die Teilchendetektion oder bestenfalls für den nahen Infrarotbereich verwendbar.

Als Verbindungstechnologie zwischen Sensorarray und Ausleseelektronik wurde bereits die Flip-Chip-Technologie erwähnt. Dabei werden Sensor und Elektronik auf separaten Wafern mit unterschiedlichen Halbleitertechnologien hergestellt und danach chip- oder waferweise mit Bump Bonds oder Mikrolötverbindungen z.B. Solid-liquid interdiffusion bonding (Slid) kontaktiert. Eine neuere Entwicklung geht noch einen Schritt weiter. Bei der SOIPIX-Technologie (siehe z.B. T. Gg. Tsuru et al., "Development and Performance of Kyoto's X-ray Astronomical SOI pixel (SOIPIX) sensor", arXiv.org > astro-ph > arXiv:1408.4556v1) wird mit Hilfe des SOI-Verfahrens (silicon on insulator) auf einem Sensorpixel-Wafer, der auch als Trägersubstrat dient, eine dünne monokristalline Siliziumschicht aufgebracht, in die anschließend die Ausleseelektronik in Form von CMOS-Transistoren integriert wird. Das Trägersubstrat mit den Sensorpixeln und die dünne monokristalline Siliziumschicht mit der Ausleseelektronik sind dabei durch eine Isolatorschicht aus Siliziumdioxid voneinander isoliert. Zur Verbindung der Ausleseelektroden der Sensorpixel mit den zugehörigen CMOS-Verstärkern werden Kontaktöffnungen in die Siliziumdioxidschicht geätzt. Weitere Details zur SOIPIX-Technologie können der zitierten Veröffentlichung entnommen werden. Die SOIPIX-Technologie hat das Potenzial, kompakte Detektorsysteme mit sehr kleinen Pixeln kostengünstig herzustellen. Als Sensoren werden bisher allerdings nur pin-Dioden-Arrays verwendet. Die Verwendung von APD-Arrays wird auf Grund der erwähnten Nachteile nicht in Betracht gezogen.

Angesichts der geschilderten Probleme ist es eine Aufgabe der Erfindung, ein APD-Array bereitzustellen, das eine gute Ortsauflösung bei einem hohen Füllfaktor aufweist.

Die Aufgabe wird gelöst durch ein Avalanche-Photodioden-Array nach Anspruch 1 und Anspruch 6. Weiterbildungen der Erfindung sind in den Unteransprüchen angegeben.

Weitere Merkmale und Zweckmäßigkeiten der Erfindung ergeben sich aus der Beschreibung von Ausführungsbeispielen anhand der beigefügten Figuren.

Fig. 1    zeigt schematisch eine Schnittdarstellung eines Ausschnitts eines Avalanche-Photodioden-Arrays einer ersten Ausführungsform senkrecht zu den Hauptoberflächen des Avalanche-Photodioden-Arrays.

Fig. 2    zeigt schematisch eine Schnittdarstellung eines Ausschnitts eines Avalanche-Photodioden-Arrays einer zweiten Ausführungsform senkrecht zu den Hauptoberflächen des Avalanche-Photodioden-Arrays.

Fig. 3    zeigt schematisch eine Schnittdarstellung eines Ausschnitts eines Avalanche-Photodioden-Arrays einer Abwandlung der zweiten Ausführungsform senkrecht zu den Hauptoberflächen des Avalanche-Photodioden-Arrays.

Fig. 4    zeigt schematisch eine Schnittdarstellung eines Ausschnitts eines Avalanche-Photodioden-Arrays einer zweiten Ausführungsform senkrecht zu den Hauptoberflächen des Avalanche-Photodioden-Arrays zur Erläuterung eines möglichen Vorgehens bei der Herstellung derselben.

Fig. 5    zeigt beispielhaft die schematische Darstellung einer monolithischen Verbindung eines erfindungsgemäßen APD-Arrays mit der Ausleseelektronik nach der SOIPIX-Technologie.

Fig. 6    zeigt einen Ausschnitt eines beispielhaften erfindungsgemäßen APD-Arrays bei einer Draufsicht auf die erste Hauptoberfläche 101.

Fig. 7    zeigt schematisch den prinzipiellen Aufbau einer Reach-Through-Avalanche-Photodiode und den Feldstärkeverlauf senkrecht zur Chipvorder- undrückseite beim Betrieb.

Erste Ausführungsform

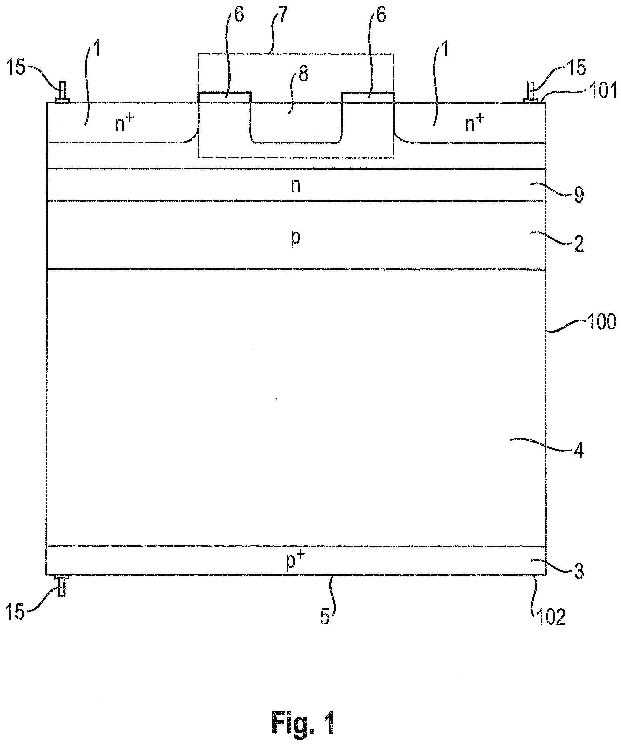

Figur 1 zeigt schematisch einen Schnitt senkrecht zu den Hauptoberflächen eines Avalanche-Photodiode-Arrays einer ersten Ausführungsform. In dem Schnitt ist ein Halbleitersubstrat 100 (z.B. ein hochohmiges Siliziumsubstrat) mit einer ersten Hauptoberfläche 101 (Chipvorderseite bzw. Chipoberseite) und einer zweiten Hauptoberfläche 102 (Chiprückseite bzw. Chipunterseite) erkennbar, in dem das Avalanche-Photodioden-Array ausgebildet ist. Bei dem als Beispiel gezeigten Abschnitt eines Reach-Through-Avalanche-Photodiodenarrays sind zwei benachbarte Pixel (Bildzellen) bestehend aus zwei Anodenbereichen 1 zusammen mit dem die beiden Anodenbereiche voneinander trennenden Pixelisolationsbereich 7, den sich die beiden Pixel in der Figur hälftig teilen, dargestellt. Ein Pixel umfasst also jeweils einen Anodenbereich 1 sowie die Hälfte des den Anodenbereich zu den Nachbarpixeln hin abgrenzenden Pixelisolationsbereichs. Bei quadratischen Anodenbereichen würden beispielsweise alle Pixelisolationsbereiche 7 zusammen ein Kreuzgitter bilden, wie anhand der Figur 6 veranschaulicht, die einen Ausschnitt des APD-Arrays bei einer Draufsicht auf die erste Hauptoberfläche 101 zeigt. Es versteht sich, dass in einem APD-Array alle Pixelisolationsbereiche 7 so miteinander verbunden sein müssen, dass alle Anodenbereichen 1 voneinander isoliert sind. Die Ausgestaltung des Pixelisolationsbereichs 7 an den "Kreuzungen" des in Fig. 6 dargestellten Kreuzgitters ist beispielsweise analog zu der Ausgestaltung der Pixelisolationsbereiche 7 nach der soeben gegebenen Definition.

Am Rande des Arrays sind Vorkehrungen zu treffen, damit das Verhalten der Randpixel sich nicht zu stark von jenem der Pixel in der Mitte des Arrays unterscheidet. Insbesondere muss dort auch durch geeignete Schutzstrukturen (wie z.B. Guardringe) für einen geordneten Abbau des Feldes gesorgt werden, um ungewollte Ladungsträgergeneration an dieser Stelle zu vermeiden. Die erwähnten Vorkehrungen sind im Stand der Technik hinreichend bekannt, so dass sie hier nicht im Detail diskutiert werden, zumal der Fokus der Erfindung nicht auf dem geeigneten Design des Randes des Arrays liegt.

Während in Fig. 1 die beiden Anodenbereiche 1 an der Chipvorderseite oder ersten Hauptoberfläche 101 ausgebildet sind, ist an der Chiprückseite oder zweiten Hauptoberfläche 102 ein p-dotierter Kathodenbereich 3 ausgebildet, der, da die zweite Hauptoberfläche 102 im Betrieb das Strahlungseintrittsfenster 5 ist, nachfolgend auch als Strahlungseintrittsseitenbereich 3 bezeichnet wird. Der Kathodenbereich 3 sollte sich zwar bevorzugt über die ganze Fläche des APD-Arrays erstrecken, muss deshalb aber nicht über die ganze Fläche hinweg gleichförmig sein. Beispielsweise ist es denkbar, dass der Kathodenbereich 3 lediglich am Rande des APD-Arrays so ausgestaltet ist, dass bei Bedeckung mit einer Kathodenelektrode (in der Figur 1 mit dem Bezugszeichen 15 bezeichnet) sich ein ohmscher Kontakt ausbildet. In der übrigen Fläche kann demgegenüber der Kathodenbereich so ausgebildet sein, dass er sehr flach ist, um die Quanteneffizienz bei der Strahlungskonversion zu optimieren. Auch können auf der zweiten Hauptoberfläche 102 weitere optische Deckschichten zur Verbesserung der Quanteneffizienz vorhanden sein, auch wenn dies in der Figur nicht gezeigt ist.

Das Bezugszeichen 4 bezeichnet eine schwach p-dotierte oder n-dotierte bzw. nur intrinsisch leitende Driftregion 4, das Bezugszeichen 2 eine p-dotierte Multiplikationsschicht. Bei SLIKs wäre die Driftregion niederohmiger als bei RT-APDs, da in letzterem Falle zumindest Teile der Driftregion die Funktion der Multiplikationsschicht übernehmen.

Auch wenn dies anhand von Fig. 1 nicht direkt ersichtlich ist, so erstreckt sich bei einer bevorzugten Implementierung der Erfindung die Multiplikationsschicht 2 in einer Ebene parallel zur ersten Hauptoberfläche 101 über den gesamten Bereich des APD-Arrays. Dadurch kann in einer Ebene parallel zur ersten Hauptoberfläche 101 für eine möglichst homogene Verstärkung im gesamten APD-Array gesorgt werden. Weiter bevorzugt erstreckt sich die Multiplikationsschicht 2 möglichst homogen unter den Anodenbereichen 1 und den Pixelisolationsbereichen 7. Dadurch wird vermieden, dass infolge von Schwankungen in der Dotierung der Multiplikationsschicht 2 in einer Ebene parallel zur ersten Hauptoberfläche 101 Variationen des elektrischen Feldes in einer Ebene parallel zur ersten Hauptoberfläche 101 erzeugt werden, die zu Inhomogenitäten in der Verstärkung führen.

Oberhalb der Multiplikationsschicht 2, also, bezogen auf die Richtung senkrecht zu den Hauptoberflächen, unterhalb der Anodenbereiche 1 und der Pixelisolationsbereiche 7, ist eine n-dotierte Feldabbauschicht 9 angeordnet. Wie im Falle der Multiplikationsschicht 2 erstreckt sich bei einer bevorzugten Implementierung die Feldabbauschicht 9 in einer Ebene parallel zur ersten Hauptoberfläche 101 über den gesamten Bereich des APD-Arrays. Ebenso erstreckt sich die Feldabbauschicht 9 bevorzugt möglichst homogen unter den Anodenbereichen 1 und den Pixelisolationsbereichen 7.

Zur Gewährleistung einer homogenen Verstärkung im gesamten APD-Array ist eine möglichst homogene laterale Verteilung des elektrischen Feldes unterhalb der n-dotierten Anodenbereiche 1 und unterhalb der Pixelisolationsbereiche 7 notwendig. Dieses Ziel wird durch das Vorhandensein der Feldabbauschicht 9 erreicht, die wie eine großflächige Zwischenanode wirkt. Da die beim Betrieb des APD-Arrays vollständig verarmte Feldabbauschicht 9 das elektrische Feld bis weit unterhalb des Einsatzes der Trägermultiplikation abbaut, sorgt die Feldabbauschicht 9 des Weiteren dafür, dass am Rande der Anodenbereiche und bei den Pixelisolationsbereichen 7 die elektrischen Felder stark reduziert sind. Dadurch werden Durchbrüche an den Pixelrändern vermieden sowie die Langzeitstabilität verbessert, indem die Injektion hochenergetischer ("heißer") Ladungsträger in den Isolator an den Halbleiter-Isolator-Grenzflächen vermieden wird.

Für die Ausgestaltung des Pixelisolationsbereiches 7 gibt es verschiedene Möglichkeiten, von denen jede in Kombination mit der erwähnten Feldabbauschicht 9 zum Einsatz kommen kann:

Wie in Fig. 1 ersichtlich ist, ist im Pixelisolationsbereich 7 an der ersten Hauptoberfläche 101 eine p-dotierte Stoppregion 8 ausgebildet. Diese dient der lateralen Isolation der n-dotierten Anodenbereiche 1 voneinander. Durch diese Stoppregion 8 wird eine Verbindung von Anodenbereichen 1 miteinander durch eine sich infolge positiver Festladungen an der Silizium-Siliziumdioxid-Grenzfläche ausbildende Elektronenschicht verhindert (Hier wird angenommen, dass anodenseitig das Halbleitersubstrat mit einer Isolationsschicht in Gestalt eines Feldoxids bedeckt ist).

Während in Figur 1 die Stoppregion 8 von den Anodenbereichen 1 beabstandet ist (mit einer Isolationsschicht 6 über dem Zwischenraum zwischen der Stoppregion 8 und den Anodenbereichen 1) kann alternativ oder zusätzlich die p-Dotierung auch in dem gesamten Pixelisolationsbereich 7 zwischen zwei Anodenbereichen 1 ausgebildet sein. Letzteres Vorgehen wird als p-spray-Isolation bezeichnet, da die p-Dotierung in diesem Fall um Größenordnungen schwächer ist als die starke n-Dotierung der Anoden und daher großflächig bzw. unstrukturiert in die erste Hauptoberfläche 101 eingebracht werden kann. Gegenüber dem Vorhandensein einer Stoppregion 8 hat dieses Vorgehen u.a. den Vorteil, dass die Zwischenräume zwischen der Stoppregion 8 und den Anodenbereichen 1 entfallen und die Breite des Pixelisolationsbereichs 7 demzufolge schmaler ist.

Eine weitere Möglichkeit, die Anodenbereiche 1 voneinander zu isolieren, besteht darin, anstelle der Stoppregion 8 oder der p-spray-Isolation eine MOS-Isolationsstruktur in den Pixelisolationsbereich 7 zwischen jeweils zwei Anodenbereichen 1 einzufügen. Im Grunde reicht es aus, wenn diese MOS-Isolationsstruktur lediglich in einem Teil des Pixelisolationsbereich 7 zwischen zwei Anodenbereichen 1 so ausgebildet ist, dass eine Isolation der angrenzenden Anodenbereiche voneinander gewährleistet ist (bei quadratischen Anodenbereichen 1 z.B. in Gestalt eines Kreuzgitters). Die MOS-Isolationsstruktur kann aber natürlich auch den gesamten Pixelisolationsbereich 7 einnehmen.

Eine vorstehend erwähnte MOS-Isolationsstruktur ist so aufgebaut, dass oberhalb der ersten Hauptoberfläche 101 eine leitende Isolations-Steuerschicht (durch eine Isolationsschicht vom Halbleitersubstrat getrennt) angeordnet ist. An die leitende Isolations-Steuerschicht wird dann ein Potential relativ zu den Anodenbereichen angelegt, dass geeignet ist, die sich an der Silizium-Siliziumdioxid-Grenzfläche infolge positiver Festladungen ausbildende Elektronenakkumulationsschicht zu verarmen und dadurch die Anodenbereiche 1 voneinander zu isolieren.

Von den Erfindern wurde noch eine weitere Möglichkeit der Ausgestaltung der Pixelisolationsbereiche 7 erkannt. Man kann sowohl bei der Ausbildung der Stoppregion 8 als auch der Ausbildung der spray-Isolation anstelle einer p-Dotierung auch eine n-Dotierung verwenden. Dies erscheint zunächst widersinnig, da ja gerade eine die Anodenbereiche 1 miteinander verbindende Elektronenschicht vermieden werden soll. Die Erfinder haben jedoch erkannt, dass die negative Raumladung der Multiplikationsschicht, die beim Betrieb durch die angelegte Sperrspannung zwischen Anodenbereichen 1 und Kathodenbereich 3 entsteht, für eine vollständige Verarmung des Halbleiters im Pixelisolationsbereich 7 sorgt, sodass eigentlich auf die drei vorstehend genannten zusätzliche Isolationsmaßnahmen verzichtet werden kann. Eine Kombination der n-Dotierung mit der oben erwähnten MOS-Isolationsstruktur kann jedoch vorteilhaft sein, um mit deren Potenzial auf technologisch bedingte Dotierungsschwankungen zu reagieren oder um eine recht genaue Einstellung der Avalancheverstärkung unterhalb des Pixelisolationsbereiches vorzunehmen. Allerdings resultiert aus der vollständigen Verarmung des Halbleiters im Pixelisolationsbereich 7 allein durch die genannte Sperrspannung auch eine Absenkung des Potentials gegenüber den Anodenbereichen, was zu Feldinhomogenitäten und damit zu einer geringeren Verstärkung unterhalb der Pixelisolationsbereich 7, also zu einem verringerten Signal an diesen Stellen, führt. Durch das Einbringen einer n-Dotierung in den Pixelisolationsbereichen kann hier den Feldinhomogenitäten entgegengewirkt werden. Welche Dotierungsparameter hier im Einzelnen zu wählen sind, hängt von den Dotierungsparametern der Multiplikationsschicht 2 und der Feldabbauschicht 9 sowie von der beim Betrieb angelegten Sperrspannung ab und kann vom Fachmann im Einzelfall im Rahmen einer Bauelementesimulation auf einfache Weise ermittelt werden.

Die Schritte zur Herstellung eines erfindungsgemäßen APD-Arrays werden im Folgenden skizziert, wobei nicht explizit aufgeführte Schritte identisch bzw. analog zu jenen sind, die auch bei der Herstellung von im Stand der Technik bekannten APD-Arrays zum Einsatz kommen.

Zur Ausbildung des Kathodenbereichs 3 werden Akzeptoren (z.B. Bor) mit hoher Dosis an der zweiten Hauptoberfläche (also der Rückseite) eines in der Regel hochohmigen Halbleitersubstrats (z.B. 2 kOhm-cm) in dieses eingebracht. An der gegenüberliegenden ersten Hauptoberfläche werden die Anodenbereiche 1 durch Einbringen von Donatoren (z.B. As oder P) mit hoher Dosis ausgebildet. In beiden Fällen erfolgt die Einbringung bevorzugt mittels Implantation. Die Dosis sollte so hoch sein, dass die Ausbildung eines ohmschen Übergangs zu den Kontakten (abhängig von der verwendeten Metallisierung) möglich ist, in aller Regel liegt hierfür die Dosis zwischen $10^{14}/cm^2$ und $10^{16}/cm^2$. In den Figuren bezeichnet das Bezugszeichen 15 allgemein einen Kontakt, unabhängig von dessen funktionaler Bestimmung oder Lage. Beim Kathodenbereich 3 kann, wie schon oben erwähnt, die Dosis außerhalb des Kontaktbereichs auch anders gewählt werden, insbesondere auch niedriger (bis hinunter zu z.B. $10^{12}/cm^2$. Um eine hohe Nachweiseffizienz von Photonen mit geringer Absorptionslänge, also Licht im UV-Bereich oder weiche Röntgenstrahlung, zu erzielen, stehen für die Ausbildung der Kathode neben der direkten Implantation von Bor in Silizium technologisch auch andere Realisierungsmöglichkeiten zur Verfügung, die unter den Begriff 'dünne Eintrittsfenster' (englisch: thin entrance window) fallen. Bekannt sind das Aufwachsen einer sehr dünnen Silizium-Epitaxieschicht mit hoher Borkonzentration, oder das epitaktische Aufwachsen reiner Borschichten oder das Abscheiden von sehr dünnen Polysiliziumschichten ebenfalls mit hoher Borkonzentration. Die Erfindung ist nicht auf eine spezielle technologische Ausführungsform des Kathodenbereiches beschränkt.

Die Multiplikationsschicht 2 kann beispielsweise mittels einer p-dotierten Epitaxieschicht ausgebildet werden. Die Dicke der Epitaxieschicht (z.B. 2-50 μm) hängt dabei von der gewählten Dotierung (z.B. zwischen $10^{14}/cm^3$ und $5·10^{15}/cm^3$) ab und sollte umso geringer sein, je höher die Dotierung ist.

Wie die Multiplikationsschicht ausgebildet wird, hat Einfluss auf den Verlauf des elektrischen Feldes beim Betrieb des APD-Arrays:

Eine konstante p-Dotierung der Multiplikationsschicht 2, z.B. innerhalb einer Epitaxieschicht, ergibt einen linearen Anstieg des elektrischen Feldes mit einem Maximum am Übergang der Multiplikationsschicht 2 zur n-dotierten Feldabbauschicht 9. Derartig inhomogene vertikale Feldverteilungen führen jedoch zu einem schlechten k-Faktor und zu einem erhöhten Zusatzrauschen, weil zumindest im Feldmaximum die Löcher stark zur Multiplikation beitragen. Homogenere vertikale elektrische Felder lassen sich realisieren, wenn die Multiplikationsschicht 2 durch Ionenimplantation mit hohen Energien erzeugt wird. Wenn dabei die p-Dotierung zwischen dem Konzentrationsmaximum und der n-dotierten Schicht 9 stark abfällt, ist das vertikale elektrische Feld in dieser Region nahezu konstant.

Wenn die Multiplikationsschicht 2 z.B. durch Ionenimplantation von Bor mit hoher Energie erfolgt, sollte die Dosis geringer als jene für den Kathodenbereich 3 sein. Da die Multiplikationsschicht 2 näher an der ersten Hauptoberfläche 101 liegen soll, wird von der ersten Hauptoberfläche 101 her implantiert, z.B. mit einer Energie zwischen 500 keV und 12 MeV und einer Dosis zwischen $10^{12}$/cm$^2$ und $4 \cdot 10^{12}$/cm$^2$.

Je tiefer das Maximum implantiert wird, also je weiter dieses von der ersten Hauptoberfläche entfernt ist, desto weiter ausgedehnt ist die Multiplikationsschicht und desto niedriger kann das elektrische Feld eingestellt werden, um eine bestimmte Verstärkung zu erzielen. Kleine elektrische Feldstärken führen wiederum zu einem kleinen k-Faktor und somit wie bei den SLIK-APDs zu einem geringen Zusatzrauschen.

Die Feldabbauschicht 9 kann ebenfalls mittels Ionenimplantation (z.B. von P) eingebracht werden, wobei von der ersten Hauptoberfläche 101 her mit hoher Energie implantiert wird. Die Energie ist so zu wählen, dass die Feldabbauschicht 9 an die Multiplikationsschicht 2 zur Seite der ersten Hauptoberfläche 101 hin angrenzt (z.B. zwischen 400 keV und 1 MeV). Die Dosis liegt bevorzugt um zwei bis drei Größenordnungen niedriger als jene für die Ausbildung der Anodenbereiche 1, z.B. im Bereich zwischen $7 \cdot 10^{11}$/cm$^2$ und $3 \cdot 10^{12}$/cm$^2$. Dabei wird die Dotierung so gewählt, dass in der Feldabbauschicht 9 ein großer Teil des elektrischen Feldes abgebaut wird, die Schicht aber beim Sensorbetrieb noch verarmt bleibt.

Zweite Ausführungsform

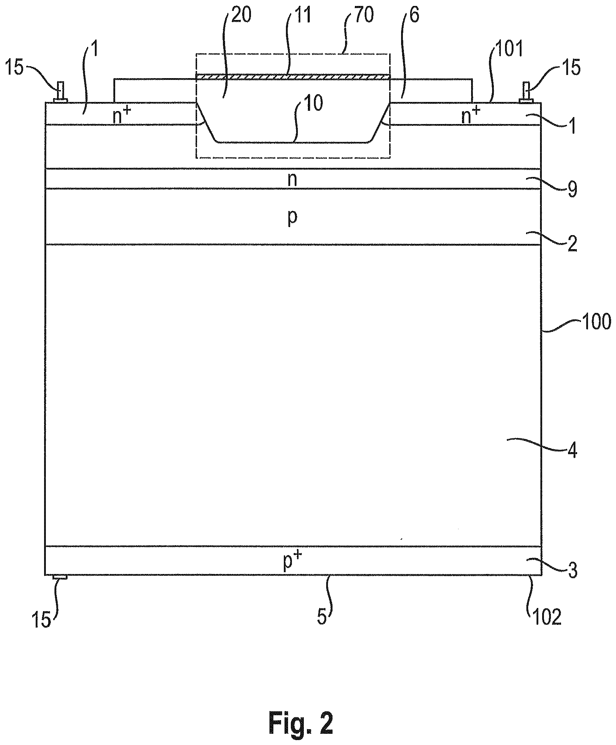

Die in Figur 2 gezeigte Schnittdarstellung einer zweiten Ausführungsform eines erfindungsgemäßen APD-Arrays weist eine große Übereinstimmung mit der Schnittdarstellung von Figur 1 auf. Insbesondere beziehen sich gleiche Bezugszeichen auf gleiche Merkmale, die identisch zu jenen in Figur 1 sind. Der Unterschied der zweiten Ausführungsform zur ersten Ausführungsform besteht in einer andersartigen Implementierung des Pixelisolationsbereichs, weshalb letzterer in Fig. 2 das Bezugszeichen 70 hat.

Der im Zusammenhang mit der ersten Ausführungsform beschriebene p-dotierte Bereich zwischen den Anodenbereichen 1, also die Stoppregion 8 oder die p-spray-Isolation, kann sich nachteilig auf den Füllfaktor auswirken. Weil die Diode zwischen den n-dotierten Anodenbereichen 1 und dem p-dotierten Bereich für eine Trennung der Anodenbereiche voneinander in Sperrrichtung gepolt sein muss, ist das Potenzial des p-dotierten Bereichs negativer als das der angrenzenden Anodenbereiche 1. Dies führt zu einem negativeren Potential des unterhalb des p-dotierten Bereichs liegenden Abschnitts der Multiplikationsschicht 2, wodurch das elektrische Feld und damit die Verstärkung an diesem Abschnitt verringert sind. Analoges gilt für den oben erwähnten MOS-Isolationsbereich. Als Folge ist die Verstärkung über den APD-Array hinweg nicht mehr homogen, wenn auch die Feldabbauschicht 9 dieser Inhomogenität entgegenwirken kann.

Für einige Einsatzgebiete spielt die Homogenität der Verstärkung nur eine untergeordnete Rolle. Insbesondere, wenn die Abmessung bzw. Fläche der Anodenbereiche 1 nicht zu klein ist, d.h. groß gegenüber der Breite bzw. Fläche des Pixelisolationsbereichs, können bei den Pixelisolationsbereichen auftretende Signalverluste oft vernachlässigt werden. Für derartige Anwendungen können daher die im Zusammenhang mit der ersten Ausführungsform beschriebenen Pixelisolationsbereiche eingesetzt werden. Andererseits gibt es Anwendungen, bei denen eine hohe Ortsauflösung, also kleine Pixel, oder ein guter Füllfaktor erforderlich sind. Beispielsweise sind in der Spektroskopie Signalverluste an den Pixelgrenzen störend. Für diese Anwendungen eignen sich insbesondere die APD-Arrays der zweiten Ausführungsform.

Wie in Fig. 2 gezeigt, ist bei der zweiten Ausführungsform im Pixelisolationsbereich 70 eine Ausnehmung bzw. Vertiefung 20 im Halbleitersubstrat 100 ausgebildet. Diese Ausnehmung 20 ist mit einem Isolator 6, beispielsweise SiO$_2$, gefüllt. Wenn beim Betrieb des APD-Arrays der Bereich unterhalb der Ausnehmung 20 vollständig verarmt ist, dann ist für eine hinreichende Isolation der Anodenbereiche 1 voneinander gesorgt. Die Grenzfläche 10 zwischen Isolator 6 und Halbleitersubstrat 100 an der Unterseite der Ausnehmung 20 sollte daher bevorzugt in einer Tiefe liegen, in der beim Betrieb der Bereich unterhalb der Anodenbereiche 1 verarmt ist. Die nicht verarmten Anodenbereiche 1 sollten daher oberhalb der Tiefe der Grenzfläche 10 liegen, also näher zur ersten Hauptoberfläche 101 hin. Aufgrund des exponentiellen Zusammenhangs zwischen Potential und Ladungsträgerdichte reicht eine Potentialdifferenz von weit weniger als 1V zu den Anodenbereichen 1 schon aus, um einen parasitären Elektronenkanal an der Grenzfläche 10 zu unterdrücken. Um eine homogene Verstärkung zu gewährleisten, sollte das Potential an der Grenzfläche 10 aber nicht zu negativ sein.

Bevorzugt sollte die Breite des Pixelisolationsbereichs 70 klein sein. Dadurch wird im verarmten Halbleiter der Potentialunterschied zwischen der Grenzfläche 10 und den seitlich dazu benachbarten Gebieten unterhalb der Anodenbereiche 1 klein gehalten, wodurch für eine homogene Ladungssammlung und Verstärkung gesorgt wird. Gleichzeitig wird dadurch der Flächenanteil der Pixelisolationsbereiche gering gehalten, was sich ebenfalls positiv auf den Füllfaktor auswirkt. Ein weiterer Vorteil schmaler Pixelisolationsbereiche liegt darin, dass der Anteil des an der Si-SiO2-Grenzfläche 10 generierten Oberflächenleckstroms gering gehalten wird. Der Löcheranteil des Oberflächengenerationsstroms wird nämlich in der Multiplikationsschicht 2 ebenfalls verstärkt und erhöht insbesondere das Rauschen.

Bei einer bevorzugten Implementierung der zweiten Ausführungsform wird das Potential der Grenzfläche 10 mit einer leitfähigen Steuerschicht 11 (z.B. aus Metall oder Polysilizium) auf der Oberfläche des Isolators 6 mittels MOS-Effekt eingestellt. Wenn das Potential entlang einer gedachten Linie, die die Grenzfläche in die angrenzenden Halbleiterschichten unterhalb der Anodenbereiche 1 (also parallel zur ersten Hauptoberfläche) verlängert, nahezu konstant eingestellt wird, sind auch Potenzial- und Feldverteilung parallel zur Halbleiteroberfläche sehr homogen, was zu einer sehr gleichmäßigen Verstärkung im gesamten APD-Array führt. Eine leitfähige Steuerschicht 11, die sich zwischen den Anodenbereichen befindet und jeden Anodenbereich umrandet, bildet dann ein Gitter, das am Rand des APD-Arrays bevorzugt auf ein festes Potential gelegt werden kann.

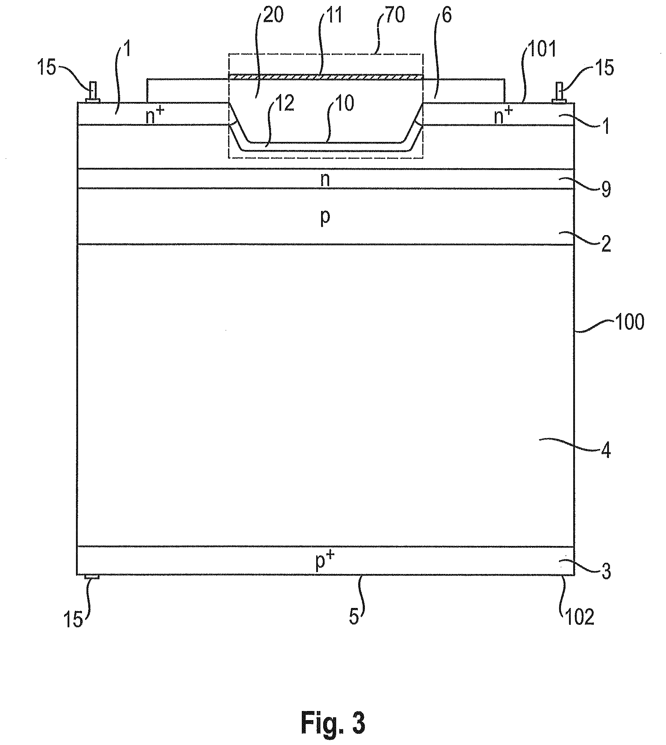

Eine weitere bevorzugte Implementierung der zweiten Ausführungsform ist in Fig. 3 dargestellt. Hierbei ist alternativ oder zusätzlich zur leitfähigen Steuerschicht 11 eine n-dotierte Grenzflächendotierungsschicht 12 unmittelbar unterhalb der Grenzfläche 10 vorhanden. Hierbei steht der Gedanke im Hintergrund, dass eine Spannung am Metallkontakt einer MOS-Struktur über die Kapazität der MOS-Struktur in eine Grenzflächenladung umgerechnet werden kann. Die Grenzflächendotierungsschicht 12 ist im Betrieb bei anliegender Sperrspannung zwischen den Anodenbereichen und dem Kathodenbereich ebenfalls verarmt. Vorteilhaft gegenüber der in Fig. 2 gezeigten Ausgestaltung ist, dass das Steuerschicht-Gitter entfällt und damit auch die parasitäre Kapazität zwischen den Anodenbereichen 1 und der Steuerschicht 11.

Das Potenzial an der Grenzfläche 10 kann normalerweise mit der leitfähigen Steuerschicht 11 wesentlich genauer und flexibler eingestellt werden. Eine Kombination einer leitfähigen Steuerschicht 11 mit einer Grenzflächendotierungsschicht 12, wie in Figur 3 dargestellt, kann vorteilhaft sein, wenn die erforderliche Spannung, die an die leitfähige Steuerschicht 11 anzulegen ist, reduziert werden soll.

Die durch Avalanchemultiplikation generierten Ladungsträger verändern die Raumladung in der Multiplikationsschicht insbesondere nachdem Elektronen und Löcher durch das elektrische Feld getrennt wurden. Die Elektronen driften mit hoher Geschwindigkeit sehr schnell in die nahe gelegenen Anoden und tragen danach nicht mehr zur Raumladung bei. Die Löcher haben eine etwas geringere Beweglichkeit und driften den weiteren Weg zur Kathode. Ihr Einfluss auf die Raumladung ist größer. Sie kompensieren für eine kurze Zeit einen Teil der negativen Raumladung, der in der Multiplikationsschicht befindlichen Akzeptoren, reduzieren somit das elektrische Feld und die Verstärkung der APD. Geometrisch bedingt ist die kapazitive Kopplung der generierten Ladungsträger unterhalb der Anodenbereiche und unterhalb der Pixelisolationsbereiche etwas unterschiedlich. Das liegt daran, dass der Abstand zwischen der Multiplikationsschicht und den auf festem Potential liegenden Anodenbereichen kleiner ist als der Abstand zwischen der Multiplikationsschicht und der leitfähigen Steuerschicht. Hinzu kommt die größere relative Dielektrizitätskonstante von Silizium im Vergleich zu Siliziumdioxid. Daraus ergibt sich, dass die Potenzial- und Feldstärkeänderung in der Multiplikationsschicht infolge von generierten Ladungsträgern unterhalb der Anoden etwas geringer ist als unterhalb der Pixelisolationsbereiche. Mit der leitfähigen Steuerschicht 11 können solche Raumladungseffekte korrigiert werden, indem das elektrische Feld in der Multiplikationsschicht durch eine positivere Spannung an der Steuerschicht etwas erhöht wird.

Auch wenn in Fig. 2 und 3 jeweils eine Feldabbauschicht 9 gezeigt ist, so muss solch eine Feldabbauschicht 9 nicht zwangsweise in APD-Arrays der zweiten Ausführungsform vorhanden sein. Der durch die zweite Ausführungsform bewirkte Vorteil eines verbesserten Füllfaktors wird auch bereits ohne das Vorhandensein der Feldabbauschicht 9 bewirkt. Natürlich können aber bei einer Kombination von erster und zweiter Ausführungsform, also bei Vorhandensein der Feldabbauschicht 9 in den Beispielen gemäß der zweiten Ausführungsform, noch größere Vorteile erzielt werden, z.B. eine durch die Feldabbauschicht 9 bewirkte homogenere Verstärkung über die Fläche des APD-Arrays hinweg.

Die Absenkung der Grenzfläche 10 gegenüber der ersten Hauptoberfläche 101 lässt sich technologisch mit dem aus der Mikroelektronik bekannten lokalen Oxidationsverfahren (LOCOS) realisieren. Bei der Verwendung des LOCOS-Verfahrens entsteht der bekannte Vogelschnabelbereich, bei dem die Oxiddicke ausgehend vom Rand der Anodenbereiche 1 zunimmt, was zur allmählichen Absenkung der Grenzfläche 10 führt (Figur 2). Der Durchgriff des Potenzials der leitfähigen Steuerschicht 11 auf die Grenzfläche 10 variiert entsprechend und ist in den Randbereichen der LOCOS-Schicht stärker als in deren Zentrum. Diese Variation wird auf die Multiplikationsschicht 2 übertragen und führt dort zu einer leichten Inhomogenität im elektrischen Feld. Diese kann durch das Aufbringen einer zusätzlichen Isolatorschicht auf die LOCOS-Schicht verringert werden, indem die relativen Dickenunterschiede ausgeglichen werden. Die Herstellung einer in Fig. 2 gezeigten planaren Oberfläche durch einen eigenen Planarisierungsschritt ist eine alternative bzw. zusätzliche Möglichkeit für einen Ausgleich der Dickenunterschiede des Isolators 6. Um die Konformität des Potenzialdurchgriffs der leitfähigen Steuerschicht 11 auf die Grenzfläche 10 zu verbessern, kann auch der Isolator 6 im Bereich seiner größten Dicke abgedünnt werden (nicht in Fig. 2 gezeigt). Damit erhöht sich auch der Durchgriff des Potenzials der Steuerschicht 11 auf die Multiplikationsschicht 2, wodurch auch die Wirkung der oben beschriebenen Raumladungseffekte reduziert wird.

Die genannten technologischen Maßnahmen können sowohl einzeln als auch in beliebiger Kombination eingesetzt werden und mit der Verwendung einer Grenzflächendotierungsschicht 12 kombiniert werden. Sie sind auch nicht an den Einsatz des LOCOS-Verfahrens gebunden. Beispielsweise kann die Grenzfläche 10 anstelle oder in Kombination mit dem LOCOS-Verfahren auch durch Ätzverfahren abgesenkt werden. Wenn vor der lokalen Oxidation in die Pixelisolationsbereiche 70 eine flache Phosphordotierung eingebracht wird (z.B. mittels Implantation mit einer Dosis zwischen $3 \cdot 10^{11}/cm^2$ und $10^{12}/cm^2$), dann wandert die Dotierung durch das Segregationsverhalten von Phosphor mit der Silizium-Siliziumdioxid-Grenzfläche 10 in den Halbleiter, um dort die Grenzflächendotierungsschicht 12 zu bilden.

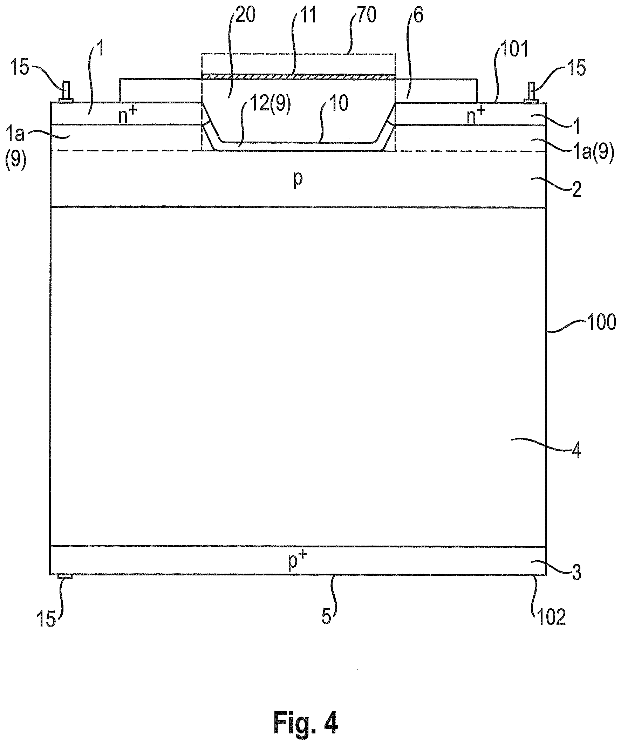

Um den technologischen Prozess kostengünstiger zu gestalten, besteht auch die Möglichkeit, die Feldabbauschicht 9 aus der n-dotierten Grenzflächendotierungsschicht 12 und den seitlich daran angrenzenden Ausläufern der Dotierung der Anodenbereiche 1 zusammenzusetzen. Die n-dotierte Feldabbauschicht 9 ist in diesem Fall nicht vollständig von den hochdotierten Anodenbereichen 1 getrennt. Ihre Dotierung kann allmählich in die Anodendotierung übergehen. Sie kann sogar durch einen schwächer dotierten Ausläufer 1a der Anodendotierung gebildet werden und seitlich in die Dotierung der Grenzflächenschicht 12 übergehen (Figur 4). Die schwächer dotierten Ausläufer 1a der Anoden und die Grenzflächendotierungsschicht 12 bilden dann gemeinsam die Feldabbauschicht 9. Der Vorteil solch eines Vorgehens ist der, dass die n-dotierte Schicht 9 nicht in einem Prozessschritt durch Ionenimplantation erzeugt wird, sondern mittels Diffusion aus den Anodenbereichen 1 sowie der beschriebenen Wanderung der Grenzflächendotierungsschicht 12 während der lokalen Oxidation im Pixelisolationsbereich 70 ausgebildet wird. Eine bei der Erzeugung der Feldabbauschicht 9 entstehende Schädigung des Siliziumkristalls wird damit gänzlich vermieden. Es sei hier noch zur Vermeidung von Missverständnissen betont, dass die Ausläufer 1a der Anodendotierung, die beim Betrieb des APD-Arrays vollständig verarmt sind, nicht als Teile der Anodenbereiche 1 angesehen werden.

Neben der Wahl der Spannung an der leitfähigen Steuerschicht 11 und/oder der Dotierungsparameter der Grenzflächendotierungsschicht 12 gibt es weitere technologische Möglichkeiten, das Potenzial an der Grenzfläche 10 und damit die Homogenität der Verstärkung zu beeinflussen. Der Potenzialunterschied zwischen der Grenzfläche 10 und den seitlich dazu benachbarten Gebieten kann durch eine tiefere SiO2-Si-Grenzfläche (dickere LOCOS-Schicht) oder durch eine flachere Anodendotierung (Arsen- statt Phosphordotierung) verringert werden. Beide Maßnahmen führen zu einem negativeren Potenzial unter den Anodenbereichen 1 auf der Höhe der SiO2-Si-Grenzfläche und vergrößern damit den Spielraum, ein homogenes laterales elektrisches Feld in der Multiplikationsschicht 2 bei gleichzeitiger Gewährleistung der elektrischen Isolation benachbarter Anodenbereiche 1 einzustellen.

Für den Betrieb der erfindungsgemäßen APD-Arrays ist es vorteilhaft, wenn die auftretenden elektrischen Feldstärken nicht zu hoch sind. In diesem Fall kommt es zu keiner oder nur einer geringen Verstärkung des an der Grenzfläche 10 erzeugten Löcherstroms.

SLIK-APD-Arrays sind somit eine bevorzugte Ausgestaltungsform der Erfindung.

Eine gleichmäßige ortsunabhängige Verstärkung, die dann gegeben ist, wenn die Summe der Signale benachbarter Pixel unabhängig vom Ort des Eintritts des Lichtsignals an der Rückseite der Diode ist, ermöglicht auch die Realisierung sehr kleiner Pixel, wie sie in pin-Diodenarrays Verwendung finden.

Die technologische Realisierung des Multiplikationsbereichs und des Kathodenbereichs kann in gleicher Weise wie bei der ersten Ausführungsform erfolgen, wie auch alle nicht in Zusammenhang mit dem Pixelisolationsbereich stehenden Ausführungen zur ersten Ausführungsform in gleicher Weise auf die zweite Ausführungsform übertragbar sind.

Weitere Abwandlungen

Moderne derzeit verwendete pin-Diodenarrays sind direkt per Flip-Chip-Technik mit der Ausleseelektronik verbunden. Die minimalen Pixelgrößen liegen im Bereich von ca. $50\mu m \times 50\mu m$. Dieses Limit ist zum einen durch den Mindestabstand benachbarter Bump-Bonds bedingt, der gegenwärtig in diesem Bereich liegt, zum anderen durch den Flächenbedarf der Transistorschaltungen im Auslese-Chip. Es ist zu erwarten, dass sich der Trend zur weiteren Miniaturisierung in der Mikroelektronik fortsetzen wird, so dass der Wunsch nach noch kleineren Pixeln absehbar ist.

Seit einigen Jahren werden Detektorsysteme entwickelt, bei denen die Ausleseelektronik mit den Sensoren mittels SOI-Technologie (silicon on insulator) monolithisch verbunden wird. Die vergleichsweise teure und platzraubende Bump-Bond-Technologie entfällt in diesem Fall. Für diese als SOIPIX bekannte Technologie werden bisher klassische pin-Diodenarrays verwendet. Daher entstand im Rahmen der vorliegenden Erfindung die Idee, die klassischen pin-Diodenarrays durch APD-Arrays zu ersetzen. Damit kann man aufgrund der verbesserten Zeitauflösung und der höheren Empfindlichkeit bei solch einem Vorgehen das Einsatzgebiet von APD-Arrays aufweisenden Detektoren erweitern. Eine Anwendung der SOIPIX-Technologie in Zusammenhang mit den erfindungsgemäßen APD-Arrays ist insbesondere auch deshalb vorteilhaft, weil nicht nur durch die intrinsische Verstärkung der APD-Arrays einfachere Verstärker mit weniger Platz- oder Leistungsbedarf verwendet werden können, wodurch z.B. kleinere Pixel zur Verbesserung der Ortsauflösung realisierbar sind. Die vorliegende Erfindung erlaubt auch die Implementierung von APD-Arrays mit kleineren Pixeln, was sie für die Kombination mit der SOIPIX-Technologie besonders interessant macht.

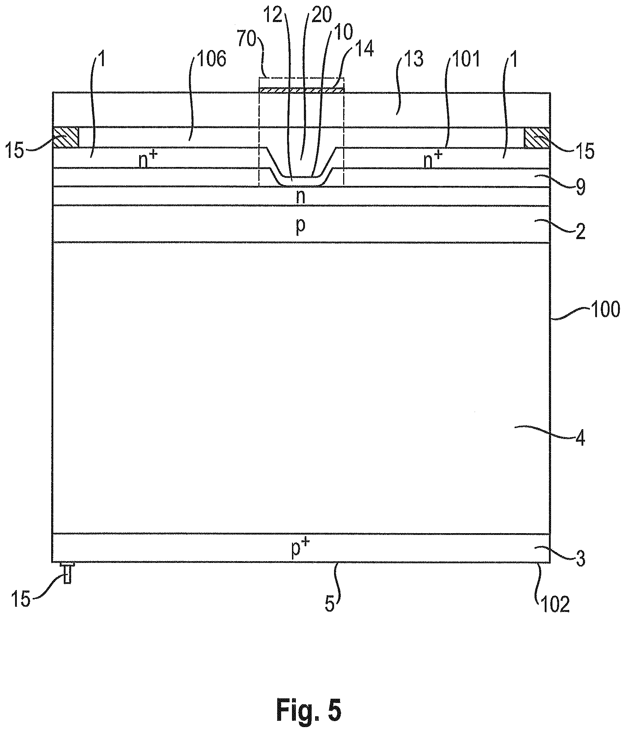

Figur 5 zeigt beispielhaft die schematische Darstellung einer monolithischen Verbindung eines erfindungsgemäßen APD-Arrays mit der Ausleseelektronik nach der SOIPIX-Technologie. Die Anodenbereiche 1 sind hierbei über Kontakte 15 mit den Eingängen der in der SOI-Schicht (bzw. dem zweiten Halbleitersubstrat) 13 ausgebildeten Ausleseverstärker (welche nicht im Detail gezeigt sind) verbunden, wobei das erste Halbleitersubstrat 100 und das zweite Halbleitersubstrat 13 durch eine Isolatorschicht 106 voneinander getrennt sind. Die Isolatorschicht 106 kann dabei in einem Schritt mit der bereits erwähnten Isolatorschicht 6, welche die Ausnehmungen 20 ausfüllt, gebildet werden und insbesondere aus dem gleichen Material (z.B. $SiO_2$) bestehen.

Die oben erwähnte leitfähige Steuerschicht 11 kann in die SOI-Schicht 13 als dotierte Siliziumschicht 14 integriert werden, die das Potenzial der Grenzfläche 10 kapazitiv steuert. Alternativ kann die leitfähige Steuerschicht auch als Polysilizium- oder Metallelektrode ausgebildet sein. Aufgrund der begrenzten Durchbruchsfestigkeit der sehr dünnen Oxide in der SOI-Elektronik darf die Steuerspannung für die leitfähige Steuerschicht 14 - wenn überhaupt - nur im Bereich weniger Volt liegen. Hier bietet sich die Verwendung der Grenzflächendotierungsschicht 12 an, um die Steuerspannung in einen für die SOI-Elektronik geeigneten Bereich zu verschieben.

Die Erfindung ist nicht auf eine bestimmte Gestalt der einzelnen Anodenbereiche beschränkt. Diese können z.B. eine quadratische oder rechteckige Gestalt aufweisen. Denkbar ist auch eine unterschiedliche Anodengestalt und/oder Anodengröße an unterschiedlichen Stellen des APD-Arrays, was in der Regel zu einer unterschiedlichen Gestalt und Größe der Pixel führt.

Wie sich aus der obigen Beschreibung ergibt, kann jede der möglichen Ausgestaltungen gemäß der zweiten Ausführungsform mit jeder der möglichen Ausgestaltungen gemäß der ersten Ausführungsform kombiniert werden.

Weiterhin ist ersichtlich, dass die vorliegende Erfindung auf APD-Pixel-Arrays gerichtet ist, bei denen die Pixelstruktur aus voneinander getrennten Anodenbereichen 1 resultiert, wohingegen die Kathoden der einzelnen Dioden alle miteinander verbunden sind, indem der gesamte Array einen homogenen unstrukturierten Kathodenbereich 3 aufweist. Die fehlende Pixelstruktur bei dem in der zweiten Hauptoberfläche 102 ausgebildeten Kathodenbereich 3 ist deshalb von Vorteil, weil die Strahlung bei den erfindungsgemäßen APD-Pixel-Arrays auf die zweite Hauptoberfläche 102 auftrifft, diese also die Strahlungseintrittsseite bei der Detektion ist.

Schließlich sei noch erwähnt, dass die Erfindung insbesondere bei APD-Arrays auf Siliziumbasis angewendet werden kann und bevorzugt bei zur Detektion von elektromagnetischer Strahlung geeigneten Reach Through-APDs oder SLIK-APDS. Insbesondere können erfindungsgemäße APD-Arrays zur Detektion von sichtbarem Licht, von UV-Strahlung und von Röntgenstrahlung mit einer Energie der Röntgenphotonen zwischen 100 eV und 5keV eingesetzt werden. Der gesamte Wellenlängenbereich, in dem eine Detektion stattfinden kann, hängt von der Beschaffenheit des Strahlungseintrittsfensters an der zweiten Hauptoberfläche ab. Der oben spezifizierte Strahlungsbereich umfasst bei Umrechnung in Wellenlängen in etwa den Bereich von ca. 0,2 nm bis 700 nm.

Die beschriebenen APD-Pixel-Arrays werden im Sensorbetrieb im Wesentlichen so betrieben, dass durch das Anlegen einer Sperrspannung zwischen Kathodenbereich 3 und Anodenbereichen 1 der gesamte Halbleiter zwischen Kathodenbereich 3 und Anodenbereichen 1 mit Ausnahme des Kathodenbereichs 3 und der Anodenbereiche 1 selbst sowie gegebenenfalls vorhandener p-stop-Regionen 8 oder p-spray-Regionen im Pixelisolationsbereich 7 verarmt ist.

Bezugszeichen

1 - Anodenbereich (n+ dotiert) - nicht verarmt
1a - schwächer dotierter Ausläufer der Anode (1) - verarmt
2 - Multiplikationsschicht (p dotiert)
3 - Kathodenbereich (p+ dotiert)
4 - Driftbereich (schwach dotiert)
5 - Lichteintrittsfenster
6 - Isolatorschicht (vorzugsweise SiO2)
7 - Pixelisolationsbereich
8 - p-Dotierung (p-stop)
9 - n-dotierte Feldabbauschicht (verarmt)
10 - Boden der Ausnehmung 20 bzw. Grenzfläche zwischen Isolatorschicht 6 und Halbleitersubstrat 100
11 - leitfähige Steuerschicht
12 - n-dotierte verarmte Grenzflächendotierungsschicht im Isolationsbereich 70
13 - zweites Halbleitersubstrat mit integrierter Ausleseelektronik - SOI Schicht
14 - leitfähige Steuerschicht integriert in das zweite Halbleitersubstrat 13
15 - Kontakt
20 - Ausnehmung
70 - Pixelisolationsbereich
100 - Halbleitersubstrat
101 - erste Hauptoberfläche
102 - zweite Hauptoberfläche

**Patentansprüche**

1. Avalanche-Photodioden-Array zur Detektion von elektromagnetischer Strahlung, mit

einem Halbleitersubstrat (100), welches eine erste Hauptoberfläche (101) und eine zweite Hauptoberfläche (102) aufweist, die einander gegenüber liegen,
einer Mehrzahl von an der ersten Hauptoberfläche (101) ausgebildeten und durch Pixelisolationsbereiche (7) voneinander getrennten n-dotierten Anodenbereichen (1)

einem an der zweiten Hauptoberfläche (102) den Anodenbereichen gegenüber angeordneten p-dotierten Kathodenbereich (3),

einem Driftbereich (4) zwischen der Mehrzahl von Anodenbereichen (1) und dem Kathodenbereich (3) und

einer unterhalb der Mehrzahl von Anodenbereichen (1) und unterhalb der Pixelisolationsbereiche (7) angeordneten p-dotierten Multiplikationsschicht (2),

wobei unterhalb der Mehrzahl von Anodenbereichen (1) und der Pixelisolationsbereiche (7) und oberhalb der Multiplikationsschicht (2) eine n-dotierte Feldabbauschicht (9) angeordnet ist.

2. Avalanche-Photodioden-Array nach Anspruch 1, wobei an der ersten Hauptoberfläche (101) in einem zwischen jeweils zwei Anodenbereichen (1) vorhandenen Pixelisolationsbereich (7) eine p-dotierte Halbleiterregion ausgebildet ist.

3. Avalanche-Photodioden-Array nach Anspruch 2, wobei die p-dotierte Halbleiterregion von den an sie angrenzenden Anodenbereichen (1) beabstandet ist.

4. Avalanche-Photodioden-Array nach Anspruch 1, wobei an der ersten Hauptoberfläche (101) in einem zwischen jeweils zwei Anodenbereichen (1) vorhandenen Pixelisolationsbereich (7) eine n-dotierte Halbleiterregion ausgebildet ist.

5. Avalanche-Photodioden-Array nach Anspruch 1, wobei an der ersten Hauptoberfläche (101) zwischen jeweils zwei Anodenbereichen ein Pixelisolationsbereich (70) ausgebildet ist, in dem eine sich von der ersten Hauptoberfläche (101) in die Tiefe des Halbleitersubstrats erstreckende Ausnehmung (20) vorhanden ist.

6. Avalanche-Photodioden-Array zur Detektion von elektromagnetischer Strahlung, mit

einem Halbleitersubstrat (100), welches eine erste Hauptoberfläche (101) und eine zweite Hauptoberfläche (102) aufweist, die einander gegenüber liegen,

einer Mehrzahl von an der ersten Hauptoberfläche (101) ausgebildeten und durch Pixelisolationsbereiche (70) voneinander getrennten n-dotierten Anodenbereichen (1),

einem an der zweiten Hauptoberfläche (101) den Anodenbereichen (1) gegenüber angeordneten p-dotierten Kathodenbereich (3),

einem Driftbereich (4) zwischen der Mehrzahl von Anodenbereichen (1) und dem Kathodenbereich (3) und

einer unterhalb der Mehrzahl von Anodenbereichen (1) und unterhalb der Pixelisolationsbereiche (70) angeordneten p-dotierten Multiplikationsschicht (2),

wobei jeder der Pixelisolationsbereiche (70) eine sich von der ersten Hauptoberfläche (101) in die Tiefe des Halbleitersubstrats erstreckende Ausnehmung (20) aufweist.

7. Avalanche-Photodioden-Array nach Anspruch 6, wobei unterhalb der Mehrzahl von Anodenbereichen (1) und der Pixelisolationsbereiche (7) und oberhalb der Multiplikationsschicht (2) eine n-dotierte Feldabbauschicht (9) angeordnet ist.

8. Avalanche-Photodioden-Array nach einem der Ansprüche 5 bis 7, wobei zumindest der Boden (10) der Ausnehmung (20) mit einem Isolator (6) bedeckt ist, bevorzugt die gesamte Ausnehmung (20) mit dem Isolator (6) ausgefüllt ist.

9. Avalanche-Photodioden-Array nach Anspruch 8, wobei auf der Oberseite des Isolators, dem Boden (10) gegenüberliegend, eine Potenzialsteuerelektrode (11) ausgebildet ist.

10. Avalanche-Photodioden-Array nach Anspruch 8 oder 9, wobei unterhalb des Bodens (10) der Ausnehmung (20), unmittelbar an den Isolator (6) angrenzend, eine n-dotierte Grenzflächendotierungsschicht (12) angeordnet ist.

11. Avalanche-Photodioden-Array nach einem der vorangehenden Ansprüche, bei dem die erste Hauptoberfläche (101) über eine Isolatorschicht (106) mit einem zweiten Halbleitersubstrat (13) verbunden ist und jeder der Mehrzahl von Anodenbereichen (1) durch die Isolatorschicht (106) hindurch mit jeweils einem Pixel eines Ausleseverstärker-Arrays elektrisch verbunden ist, welches in dem zweiten Halbleitersubstrat ausgebildet ist.

12. Verfahren zur Herstellung eines Avalanche-Photodioden-Arrays nach einem der Ansprüche 5 bis 10, bei dem die Ausnehmung (20) durch eine lokale Oxidation des Halbleitersubstrats (100) mittels der LOCOS-Technik ausgebildet wird.

13. Verfahren nach Anspruch 12, bei dem vor der Durchführung der lokalen Oxidation an den lokal zu oxidierenden Stellen Donatoren mit einer Dosis zwischen $3 \cdot 10^{11}/cm^2$ und $10^{12}/cm^2$, bevorzugt mittels Implantation, in das Halbleitersubstrat (100) eingebracht werden.

14. Verfahren nach Anspruch 13, bei dem eine n-dotierte Feldabbauschicht (9) unterhalb der Mehrzahl von Anodenbereichen (1) und der Pixelisolationsbereiche (7, 70) und oberhalb der Multiplikationsschicht (2) ausgebildet wird, indem ein Diffusionsschritt durchgeführt wird, durch den in die Anodenbereiche eingebrachte Dotanden so weit in das Halbleitersubstrat diffundieren, dass die diffundierten Dotanden zusammen mit der Grenzflächendotierungsschicht (12) die Feldabbauschicht (9) bilden.

**Claims**

1. An avalanche photodiode array for detecting electromagnetic radiation comprising

   a semiconductor substrate (100) that comprises a first main surface (101) and a second main surface (102) which are opposed to each other, a plurality of n-doped anode regions (1) formed at the main surface (101) and separated from each other by pixel insulation regions (7), a p-doped cathode region (3) arranged at the second main surface (102) opposite to the anode regions, a drift region (4) between the plurality of anode regions (1) and the cathode region (3) and a p-doped multiplication layer (2) arranged below the plurality of anode regions (1) and below the pixel insulation regions (7), wherein an n-doped field reduction layer (9) is arranged below the plurality of anode regions (1) and the pixel insulation regions (7) and above the multiplication layer (2).

2. The avalanche photodiode array according to claim 1, wherein a p-doped semiconductor region is formed at the first main surface (101) in a pixel insulation region (7) located between each two anode regions (1).

3. The avalanche photodiode array according to claim 2, wherein the p-doped semiconductor region is at a distance to the anode regions (1) adjoining thereto.

4. The avalanche photodiode array according to claim 1, wherein an n-doped semiconductor region is formed at the first main surface (101) in a pixel insulation region (7) between each two anode regions (1).

5. The avalanche photodiode array according to claim 1, wherein a pixel insulation region (70) is formed at the first main surface (101) between each two anode regions, in which pixel insulation region a recess (20) extending from the first main surface (1) into the depth of the semiconductor substrate is present.

6. An avalanche photodiode array for detecting electromagnetic radiation comprising

   a semiconductor substrate (100) comprising a first main surface (101) and a second main surface (102) opposed to each other, a plurality of n-doped anode regions (1) formed at the first main surface (101) and separated from each other by pixel insulation regions (70), a p-doped cathode region (3) arranged at the second main surface (101) opposite to the anode regions (1), a drift region (4) between the plurality of anode regions (1) and the cathode region (3) and a p-doped multiplication layer (2) arranged below the plurality of anode regions (1) and below the pixel insulation regions (70), wherein each of the pixel insulation regions (70) comprises a recess (20) extending from the first main surface (101) into the depth of the semiconductor substrate.

7. The avalanche photodiode array according to claim 6, wherein an n-doped field reduction layer (9) is arranged below the plurality of anode regions (1) and below the pixel insulation regions (7) and above the multiplication layer (2).

8. The avalanche photodiode array according to one of claims 5 to 7, wherein at least the bottom (10) of the recess (20) is covered with an insulator (6), preferably the whole recess (20) is filled with the insulator (6).

9. The avalanche photodiode array according to claim 8, wherein a potential control electrode (11) is formed at the top side of the insulator opposite to the bottom (10).

10. The avalanche photodiode array according to claim 8 or 9, wherein an n-doped interface doping layer (12) is arranged below the bottom (10) of the recess (20) immediately adjoining the insulator (6).

11. The avalanche photodiode array according to one of the preceding claims, in which the first main surface (101) is connected to a second semiconductor substrate (13) via an insulating layer (106) and each of the plurality of anode regions (1) is electrically connected through the insulating layer (106) with one respective pixel of a read-out amplifier array formed in the second semiconductor substrate.

12. A method of manufacturing an avalanche photodiode array according to one of claims 5 to 10, wherein the recess (20) is formed by a local oxidation of the semiconductor substrate (100) by means of the LOCOS technique.

13. The method according to claim 12, wherein before carrying out the local oxidation, donors are introduced into the semiconductor substrate (100) at the positions to be locally oxidized with a dose between $3 \cdot 10^{11}/\text{cm}^2$ and $10^{12}/\text{cm}^2$, preferably by means of implantation, at the positions to be locally oxidized.

14. The method according to claim 13, wherein an n-doped field reduction layer (9) is formed below the plurality of anode regions (1) and the pixel insulation regions (7, 70) and above of the multiplication layer (2) by carrying out a diffusion step by which dopants that have been introduced into the anode regions diffuse so far into semiconductor substrate that the diffused dopants form the field reduction layer (9) together with the interface doping layer (12).

**Revendications**

1. Réseau de photodiodes à avalanche pour la détection d'un rayonnement électromagnétique, comprenant

   un substrat semi-conducteur (100) qui présente une première surface principale (101) et une deuxième surface principale (102) qui sont opposées l'une à l'autre,
   une pluralité de zones d'anode dopées n (1) formées sur la première surface principale (101) et séparées les unes des autres par des zones d'isolation de pixels (7),
   une zone de cathode dopée p (3) disposée sur la deuxième surface principale (102) à l'opposé des zones d'anode,
   une zone de dérive (4) entre la pluralité de zones d'anode (1) et la zone de cathode (3) et
   une couche de multiplication dopée p (2) disposée en dessous de la pluralité de zones d'anode (1) et en dessous des zones d'isolation de pixels (7),
   dans lequel une couche de dégradation de champ dopée n (9) est disposée en dessous de la pluralité de zones d'anode (1) et des zones d'isolation de pixels (7) et au-dessus de la couche de multiplication (2).

2. Réseau de photodiodes à avalanche selon la revendication 1, dans lequel une zone semi-conductrice dopée p est formée sur la première surface principale (101) dans une zone d'isolation de pixels (7) présente entre chaque fois deux zones d'anode (1).

3. Réseau de photodiodes à avalanche selon la revendication 2, dans lequel la zone semi-conductrice dopée p est espacée des zones d'anode (1) adjacentes à celle-ci.

4. Réseau de photodiodes à avalanche selon la revendication 1, dans lequel une zone semi-conductrice dopée n est formée sur la première surface principale (101) dans une zone d'isolation de pixels (7) présente entre chaque fois deux zones d'anode (1).

5. Réseau de photodiodes à avalanche selon la revendication 1, dans lequel une zone d'isolation de pixels (70) est formée sur la première surface principale (101) entre chaque fois deux zones d'anode, dans laquelle un évidement (20) s'étendant depuis la première surface principale (101) dans la profondeur du substrat semi-conducteur est présent.

6. Réseau de photodiodes à avalanche pour la détection d'un rayonnement électromagnétique, comprenant

   un substrat semi-conducteur (100) qui présente une première surface principale (101) et une deuxième surface principale (102) qui sont opposées l'une à l'autre,
   une pluralité de zones d'anode dopées n (1) formées sur la première surface principale (101) et séparées les unes des autres par des zones d'isolation de pixels (70),
   une zone de cathode dopée p (3) disposée sur la deuxième surface principale (101) à l'opposé des zones d'anode (1),
   une zone de dérive (4) entre la pluralité de zones d'anode (1) et la zone de cathode (3) et
   une couche de multiplication dopée p (2) disposée en dessous de la pluralité de zones d'anode (1) et en dessous des zones d'isolation de pixels (70),
   dans lequel chacune des zones d'isolation de pixels (70) présente un évidement (20) s'étendant depuis la première surface principale (101) dans la profondeur du substrat semi-conducteur.

7. Réseau de photodiodes à avalanche selon la revendication 6, dans lequel une couche de dégradation de champ dopée n (9) est disposée en dessous de la pluralité de zones d'anode (1) et des zones d'isolation de pixels (7) et au-dessus de la couche de multiplication (2).

8. Réseau de photodiodes à avalanche selon l'une quelconque des revendications 5 à 7, dans lequel au moins le fond (10) de l'évidement (20) est recouvert d'un isolant (6), de préférence l'évidement entier (20) est rempli de l'isolant (6).

9. Réseau de photodiodes à avalanche selon la revendication 8, dans lequel une électrode de commande de potentiel (11) est formée sur le côté supérieur de l'isolant, à l'opposé du fond (10).

10. Réseau de photodiodes à avalanche selon la revendication 8 ou 9, dans lequel une couche de dopage d'interface dopée n (12) est disposée en dessous du fond (10) de l'évidement (20), directement adjacente à l'isolant (6).

11. Réseau de photodiodes à avalanche selon l'une quelconque des revendications précédentes, dans lequel la première surface principale (101) est connectée par le biais d'une couche d'isolant (106) à un deuxième substrat semi-conducteur (13) et chacune de la pluralité de zones d'anode (1) est chaque fois connectée électriquement à travers la couche d'isolant (106) à un pixel d'un réseau d'amplificateurs de lecture qui est formé dans le deuxième substrat semi-conducteur.

12. Procédé de fabrication d'un réseau de photodiodes à avalanche selon l'une quelconque des revendications 5 à 10, dans lequel l'évidement (20) est formé par une oxydation locale du substrat semi-conducteur (100) au moyen de la technique LOCOS.

13. Procédé selon la revendication 12, dans lequel, avant la réalisation de l'oxydation locale, des donneurs sont introduits dans le substrat semi-conducteur (100) aux positions à oxyder localement avec une dose comprise entre $3 \cdot 10^{11}/cm^2$ et $10^{12}/cm^2$, de préférence par implantation.

14. Procédé selon la revendication 13, dans lequel une couche de dégradation de champ dopée n (9) est formée en dessous de la pluralité de zones d'anode (1) et des zones d'isolation de pixels (7, 70) et au-dessus de la couche de multiplication (2), en ce qu'une étape de diffusion est réalisée, par laquelle des dopants introduits dans les zones d'anode diffusent suffisamment dans le substrat semi-conducteur de sorte que les dopants diffusés forment conjointement avec la couche de dopage d'interface (12) la couche de dégradation de champ (9).

**Fig. 1**

**Fig. 2**

**Fig. 3**

**Fig. 4**

**Fig. 5**

**Fig. 6**

**Fig. 7**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20120267746 A1

**In der Beschreibung aufgeführte Nicht-Patentliteratur**

- **N. MOFFAT et al.** Low Gain Avalanche Detectors (LGAD) for particle physics and synchrotron applications. *Journal of Instrumentation,* 13. Marz 2018
- **G. PELLEGRINI et al.** Recent Technological Developments on LGAD and iLGAD Detectors for Tracking and Timing Applications. *arXiv.org > physics > arXiv: 1511.07175*

- **T. GG. TSURU et al.** Development and Performance of Kyoto's X-ray Astronomical SOI pixel (SOIPIX) sensor. *arXiv.org > astro-ph > arXiv:1408.4556v1*